(19) Europäisches Patentamt
European Patent Office
Office européen des brevets

(11) **EP 2 128 189 B1**

(12) **EUROPEAN PATENT SPECIFICATION**

(45) Date of publication and mention
of the grant of the patent:
**04.06.2014 Bulletin 2014/23**

(21) Application number: **08710874.2**

(22) Date of filing: **30.01.2008**

(51) Int Cl.:
*C08J 5/18* (2006.01)    *B29C 55/12* (2006.01)
*C08K 3/04* (2006.01)    *C08K 5/00* (2006.01)
*C08L 101/00* (2006.01)    *H01B 3/30* (2006.01)
*H01B 3/42* (2006.01)    *H01B 17/56* (2006.01)

(86) International application number:
**PCT/JP2008/051978**

(87) International publication number:
**WO 2008/093885 (07.08.2008 Gazette 2008/32)**

(54) **BIAXIALLY ORIENTED FILM FOR ELECTRICAL INSULATION, FILM CAPACITOR CONSTITUTING MEMBER COMPOSED OF THE SAME, AND FILM CAPACITOR COMPRISING THE SAME**

BIAXIAL AUSGERICHTETER FILM FÜR ELEKTRISCHE ISOLIERUNG, DARAUS HERGESTELLTES ELEMENT EINES FOLIENKONDENSATORS UND FOLIENKONDENSATOR DAMIT

FILM À ORIENTATION BIAXIALE POUR ISOLANT ÉLECTRIQUE, COMPOSANT DE CONDENSATEUR À FILM CONSTITUÉ D'UN TEL FILM, ET CONDENSATEUR À FILM COMPORTANT UN TEL FILM

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **01.02.2007 JP 2007022830**

(43) Date of publication of application:
**02.12.2009 Bulletin 2009/49**

(73) Proprietor: **Teijin Dupont Films Japan Limited**
**Chiyoda-ku**
**Tokyo 100-0013 (JP)**

(72) Inventor: **YOSHIDA, Tetsuo**
**Anpachi-gun**
**Gifu 503-0123 (JP)**

(74) Representative: **Cockerton, Bruce Roger**
**Carpmaels & Ransford LLP**
**One Southampton Row**
**London WC1B 5HA (GB)**

(56) References cited:
EP-A1- 0 694 633         EP-A1- 1 714 998
JP-A- 2004 075 933       JP-A- 2005 041 917
JP-A- 2006 117 760       JP-A- 2006 282 971
US-A1- 2005 221 096

## Description

Technical Field

The present invention relates to biaxially oriented films suitable for electrical insulation. Specifically, the invention relates to a biaxially oriented film suitable for electrical insulation that excels in withstand voltage characteristics over a temperature range from room temperature to higher temperatures, and that has excellent processability, causing no heat degradation in the film being continuously processed to form a functional layer thereon while the film is continuously being taken up. The invention also relates to a film capacitor constituting member including the biaxially oriented film, and a film capacitor including the biaxially oriented film.

Background Art

Electrical insulation films made of a crystalline thermoplastic resin, for example, such as polypropylene resin, polystyrene resin, polyester resin, and polyphenylene sulfide resin are known. These films are used for applications such as in film capacitors, flexible printed circuit boards, and motor insulation. The film capacitor is produced by winding or laminating films in which a metal thin film such as an aluminum foil is laid over the crystalline thermoplastic resin film. The flexible printed circuit board is produced by a method such as forming a circuit on a metal thin film laminated on at least one surface of the crystalline thermoplastic resin film. The motor insulating film is used, for example, as a wedge material or a slot material that provides insulation between the coil and stator of a motor.

In response to the recent demand for smaller electric components and electronic components, there has been movement toward miniaturization or packaging of the film capacitors and motors. This has created a demand for withstand voltage characteristics not only in the conventionally required room temperature range but in a higher temperature range. Further, in automobile applications, the use of the film capacitor is not confined in the cabin but has extended to the engine room, requiring film capacitors with superior withstand voltage characteristics in a high temperature range as with the other electrical or electronic components.

For example, JP-A-2000-173855 (Patent Document 1) discloses a polyethylene-2,6-naphthalate film having an intrinsic viscosity and a degree of crystallization in specific ranges, in order to provide a capacitor polyester film that excels in heat resistance, moisture resistance, and electrical characteristics intended for use in the engine room of automobiles. Further, to provide a capacitor film having excellent dielectric characteristics or withstand voltage characteristics, JP-A-2005-289065 (Patent Document 2) discloses a thermoplastic resin film including a large amount of phenolic stabilizer.

Meanwhile, since the establishment of the method for the mass synthesis of C60 in 1990, there has been active research on fullerenes (including monomers, dimers, and trimers, derivatives, and mixtures thereof). These studies have revealed various properties of fullerene, and the use of fullerene in the film has been investigated. For example, JP-A-2006-282971 (Patent Document 3) discloses a thermoplastic resin film that has a small creep value, and reduced numbers of large protuberances formed by aggregation of fullerenes.

However, with the recent trend for smaller electrical and electronic components and the installation of these components in automobiles, there is a demand for the development of a crystalline thermoplastic resin film, suitable for electrical insulation purposes, that has higher withstand voltage characteristics not only in the vicinity of room temperature but at higher temperatures up to about 150°C.

Further, when used for electrical insulation, the film is often exposed to high temperature in the continuous process of forming a functional layer on the film while the film is being continuously taken up. For example, in an electrical insulation film produced through the process of forming a metal layer by vacuum vapor deposition, the film exposed to high temperature in this process undergoes heat deformation and produces wrinkles (hereinafter, also referred to as "heat degradation") depending on the deposition rate.

Patent Document 1: JP-A-2000-173855
Patent Document 2: JP-A-2005-289065
Patent Document 3: JP-A-2006-282971

Disclosure of the Invention

An object of the present invention is to provide a biaxially oriented film, suitable for electrical insulation, that excels in withstand voltage characteristics over a temperature range from room temperature to higher temperatures, and that has excellent processability, causing no heat deformation and wrinkles (heat degradation) in the film being continuously processed to form a functional layer thereon while the film is continuously being taken up.

The object of the present invention is achieved by a biaxially oriented film for electrical insulation according to claim 1 (Item 1).

The present invention is also inclusive of a film capacitor constituting member that includes the biaxially oriented film for electrical insulation.

Further, the present invention is inclusive of a film capacitor that includes the biaxially oriented film for electrical insulation.

In another aspect, the present invention is inclusive of the following.

Item 2. A biaxially oriented film for electrical insulation according to Item 1, wherein the fullerene is at least one selected from the group consisting of C60, C70, a dimer thereof, and a trimer thereof.

Item 3. A biaxially oriented film for electrical insulation according to Item 1 or 2, wherein the fullerene in the film has a dispersion particle diameter of 100 nm or less.

Item 5. A biaxially oriented film for electrical insulation according to any one of Items 1 through 3, wherein the fraction of (A) the fullerene with respect to a total amount of (A) the fullerene and (B) the at least one phenolic stabilizer is at least 0.001 and at most 1.0 in the formula (1) below:

```
Amount of (A) fullerene added (ppm)/(amount of (A)

fullerene added (ppm) + amount of (B) stabilizer added

(ppm)) ... (1).
```

Item 6. A biaxially oriented film for electrical insulation according to Item 1 or 5, further including (C) at least one component selected from the group consisting of a sulfur stabilizer and a phosphorus stabilizer added in an amount of 1 to 50,000 ppm with respect to the weight of the crystalline thermoplastic resin.

Item 7. A biaxially oriented film for electrical insulation according to any one of Items 1 through 6, further including 0.0001 to 0.1 weight% of inert particles.

Item 9. A biaxially oriented film for electrical insulation according to Item 1, wherein the polyester resin is polyethylene-2,6-naphthalene dicarboxylate.

Item 10. A biaxially oriented film for electrical insulation according to Item 1 or 9, wherein a catalyst of the polyester resin is a titanium compound.

Item 11. A biaxially oriented film for electrical insulation according to any one of Items 1 through 10, wherein the film is used for film capacitors or motor insulation.

Item 12. A biaxially oriented laminate film, which includes a metal layer laminated on at least one surface of a biaxially oriented film for electrical insulation of any one of Items 1 through 11.

Item 13. A film capacitor base film, which includes a biaxially oriented film for electrical insulation of any one of Items 1 through 10.

Item 14. A film capacitor constituting member, which includes a composite film including: a biaxially oriented film for electrical insulation of any one of Items 1 through 10; and a metal layer laminated on at least one surface of the biaxially oriented film.

Item 15. A film capacitor, which includes a constituting member formed by lamination of a plurality of composite films each including: a biaxially oriented film for electrical insulation of any one of Items 1 through 10; and a metal layer laminated on at least one surface of the biaxially oriented film.

Item 16. A motor insulating film, which includes a biaxially oriented film for electrical insulation of any one of Items 1 through 10.

Item 17. A motor insulating member, which includes a biaxially oriented film for electrical insulation of any one of Items 1 through 10.

The present invention was completed by finding the unknown function of fullerene that fullerenes, when added to the film as an additive, act to improve the withstand voltage of the film, and improve the withstand voltage characteristics over a temperature range from room temperature to higher temperatures.

Specifically, a film of the present invention, by inclusion of fullerene in a crystalline thermoplastic resin film, excels in withstand voltage characteristics over a temperature range from room temperature to higher temperatures, and is therefore suitable as an electrical insulation film.

Further, a film of the present invention was completed based on the finding that the inclusion of fullerene improves the film break strength, and therefore enables the film to be taken up under high tension in the production of an electrical insulation member, for example, such as in the continuous process of forming a functional layer on the film, thereby preventing heat degradation due to metallization. With this improvement in processability, the film can be suitably used as an electrical insulation film.

Best Mode for Carrying Out the Invention

The following will describe the present invention in detail.

<Crystalline Thermoplastic Resin>

The crystalline thermoplastic resin used in the present invention is a polyester resin.

The polyester resin used in the present invention is a polymer obtained by the polycondensation of diol and dicarboxylic acid. Examples of the dicarboxylic acid include terephthalic acid, isophthalic acid, 2,6-naphthalene dicarboxylic acid, 4,4'-diphenyl
dicarboxylic acid, adipic acid, and sebacic acid. Examples of the diol include ethylene glycol, 1,4-butanediol, 1,4-cyclohexanedimethanol, and 1,6-hexanediol.

Among these examples, polyethylene terephthalate, and polyethylene-2,6-naphthalene dicarboxylate (hereinafter, also referred to as "PEN") are preferable, and polyethylene-2,6-naphthalene dicarboxylate is particularly preferable considering the withstand voltage characteristics at high temperatures.

The polyester resin used in the present invention may be used either alone, or as a copolymer with other polyesters, or a blend with two or more kinds of polyesters. The other components of the copolymer or the blend are preferably 10 mol% or less, more preferably 5 mol% or less with respect to the number of moles of the repeating structure unit. Examples of the copolymer components include diol components such as diethylene glycol, neopentylglycol, and polyalkylene glycol; and dicarboxylic acid component such as adipic acid, sebacic acid, phthalic acid, isophthalic acid, terephthalic acid, naphthalene dicarboxylic acid, and 5-sodium sulfoisophthalic acid.

The polyester of the present invention can be obtained by known methods, including, for example, a method in which a polyester with a low degree of polymerization is directly obtained by the reaction of dicarboxylic acid and diol, and a method in which a polymerization reaction is performed in the presence of a polymerization catalyst, after the reaction of a lower alkylester of dicarboxylic acid with diol using an ester exchange catalyst.

The withstand voltage characteristics of a film of the present invention can be further improved by using a titanium compound as a catalyst in the production of the polyester. Preferably, the titanium compound is a titanium compound that is soluble in polyester resin. As used herein, a "titanium compound that is soluble in polyester resin" means an organic titanium compound. Specific examples include tetraethyl titanate, tetrapropyl titanate, tetrabutyl titanate, tetraphenyl titanate, or partially hydrolyzed products thereof, ammonium titanyl oxalate, potassium titanyl oxalate, and titanium tris-acetylacetonate. Other examples include products obtained by the reaction of the titanium compound with an aromatic polycarboxylic acid or an anhydride thereof, such as a trimellitic acid anhydride. Tetrabutyl titanate and titanium trimellitate are preferable among these examples. Titanium trimellitate is a compound obtained by the reaction of a trimellitic acid anhydride and a tetrabutyl titanate.

In the ester exchange method, the titanium compound may be added before, during, or after the ester exchange reaction, or immediately before the polycondensation reaction. In the esterification method, the titanium compound may be added after the esterification reaction, or immediately before the polycondensation reaction.

The content of the titanium compound in the polyester resin is preferably 5 to 20 ppm, more preferably 7 to 18 ppm, particularly preferably 8 to 17 ppm in terms of a titanium element, with respect to the weight of the polyester resin. When the content of the titanium compound is below the lower limit, the production of the polyester may be delayed. On the other hand, above the upper limit, the heat resistance stability of the product polyester may deteriorate. Further, the withstand voltage characteristics may be impaired by the deposited titanium compound.

The antimony compound commonly used as the polymerization catalyst of the polyester resin easily forms a deposit, and is required in large amounts. The deposit originating in the antimony compound impairs the withstand voltage characteristics, and the withstand voltage characteristics may not improve sufficiently even when fullerene is contained in the film as the essential component. In contrast, with the use of the titanium compound, the catalyst can be used only in small amounts needed to sustain the polymerization reaction. This reduces the deposit that inhibits the withstand voltage characteristics, and a film with excellent withstand voltage characteristics can be obtained. The deposit can be further reduced, and the withstand voltage characteristics can be improved when the titanium compound used is soluble in the polyester resin.

Considering this, the titanium compound can be used with other catalyst compounds, for example, such as an antimony compound and a germanium compound. However, when used with other catalyst compounds, it is preferable that the other catalyst compounds be used in small amounts. When the amount of non-titanium catalyst compound is large, the catalyst tends to form a deposit, which may impair the withstand voltage characteristics of the film. The mechanism by which the deposit impairs the withstand voltage characteristics is believed to be due to the electrolytic concentration caused by the deposit. When using non-titanium catalyst compounds with the titanium compound, it is preferable that the content of the non-titanium catalyst compound be 5 ppm or less, more preferably essentially zero, with respect to the weight of the polyester resin.

The inherent viscosity of the polyester resin used in the present invention is preferably 0.40 dl/g or more, more preferably 0.40 to 0.80 dl/g in o-chlorophenol at 35°C. When the inherent viscosity is below 0.4 dl/g, there might be a high incidence of cut during the film formation, and the strength of the product after the forming process may not be sufficient. On the other hand, an inherent viscosity in excess of 0.8 dl/g may reduce the productivity of the polymerization.

The crystalline thermoplastic resin used in the present invention is not necessarily required to be a single compound, and may be a blend of two or more kinds of crystalline thermoplastic resins. In this case, the other components may be the same thermoplastic resin used as the primary component, or may be different thermoplastic resins. The content of the other components in the blend is preferably 30 weight% or less, more preferably 10 weight% or less with respect to the total weight of the crystalline thermoplastic resin.

The melting point of a crystalline thermoplastic resin of the present invention preferably ranges from 230°C to 280°C, more preferably 240 to 275°C. When the melting point is below the lower limit, sufficient withstand voltage characteristics may not be obtained at high temperatures. When the melting point is in excess of the upper limit, film processability may suffer.

< (A) Fullerenes>

Examples of the fullerene used in the present invention include fullerenes, derivatives of fullerenes, and a mixture of these.

The fullerene is a spherical or elliptic carbon molecule, and is not limited as long as it satisfies an object of the present invention. Examples include C60, C70, C74, C76, C78, C80, C82, C84, C86, C88, C90, C92, C94, C96, C98, C100, and dimers and trimers of these compounds.

In the present invention, the fullerene is preferably at least one selected from the group consisting of C60, C70, a dimer thereof, and a trimer thereof. C60 and C70 are particularly preferable because they are industrially readily available, and excel in dispersibility in the resin. These fullerenes may be used in a combination of two or more, preferably in a combination of C60 and C70.

As used herein, the "fullerene derivatives" refers to compounds in which an atomic group partially forming an organic compound, or an atomic group formed of inorganic elements is bound to at least one of the carbon atoms forming the fullerene. The fullerene derivative can be used in the same fashion as is the fullerene, as long as it does not inhibit formability of the film. The fullerene derivative may improve the dispersibility of the fullerene. The fullerene used to obtain fullerene derivatives is not limited as long as it satisfies an object of the present invention, and any of the fullerenes exemplified above can be used. Examples of the fullerene derivatives include hydrogenated fullerenes, fullerene oxides, fullerene hydroxides, and halogenated (F, Cl, Br, I) fullerenes. The fullerene derivatives may contain substituents such as a carboxyl group, an alkyl group, and an amino group.

The fullerene is obtained by extraction separation from a fullerene-containing soot obtained by a method, for example, such as a resistive heating method, a laser heat method, an arc discharge method, or a combustion method. Here, it is not necessarily required to achieve complete separation, and the fraction of the fullerene can be adjusted to such an extent that the performance is not impaired. The fullerene derivative can be synthesized from fullerenes using a known method. For example, desired fullerene derivatives can be obtained by reactions such as the reaction with a nucleophilic agent (nucleophilic addition reaction), a cycloaddition reaction, a photoaddition (cyclization) reaction, and an oxidation reaction.

The amount of fullerene added in the present invention is 10 to 20,000 ppm with respect to the weight of the crystalline thermoplastic resin. The lower limit of fullerene amount is preferably 100 ppm or more, more preferably 500 ppm or more, particularly preferably 1,000 ppm or more. The upper limit of fullerene amount is preferably 15,000 ppm or less, more preferably 10,000 ppm or less. When the amount of fullerene added is below the lower limit, the withstand voltage characteristics will not be improved sufficiently. On the other hand, when the amount of fullerene added is in excess of the upper limit, no further improvements can be expected for the withstand voltage characteristics, and film breakage or surface roughness may result due to the failed dispersion during the film formation.

A fullerene of the present invention preferably has a dispersion particle diameter of 100 nm or less in the biaxially oriented film. As used herein, the "dispersion particle diameter" refers to the particle diameter of the secondary particles formed by aggregation of the fullerene, when the fullerene aggregates in the dispersion. The dispersion particle diameter is determined from the number average length of the disperse phase of 100 fullerenes along the MD direction (hereinafter, also referred to as "lengthwise direction" or "continuous film-forming direction"), by observing the cross section through the thickness taken along the line parallel to the MD direction, using a light microscope (OPTPHOT-2, 200 ×; Nikon).

When the dispersion particle diameter of the fullerene is in excess of 100 nm, the fullerene will not be dispersed sufficiently, and variation may occur in the withstand voltage characteristics.

<(B) Phenolic Stabilizer and Amine Stabilizer>

A film of the present invention additionally includes (B) at least one phenolic stabilizer. Using these stabilizers as auxiliary agents with the fullerene provides synergy for the withstand voltage characteristics, and the withstand voltage characteristics can be further improved compared with using the fullerene or the stabilizer alone.

Examples of the phenolic stabilizer include hindered phenols, of which high molecular hydroxyphenyl propionates, and high molecular hydroxybenzil benzenes are preferable. Specific examples include pentaerythrityl-tetrakis[3-(3,5-di-t-butyl-4-hydroxyphenyl)propionateJ, octadecyl-3-(3,5-di-*t*-butyl-4-hydroxyphenyl)propionate, triethylene glycol-bis[3-(3-*t*-butyl-5-methyl-4-hydroxyphenyl)propionate, and 1,3,5-trimethyl-2,4,6-tris(3,5-di-t-butyl-4-hydroxybenzil)benzene. Among these, pentaerythrityl-tetrakis[3-(3,5-di-*t*-butyl-4-hydroxyphenyl)propionate], and octadecyl-3-(3,5-di-*t*-butyl-4-hydroxyphenyl)propionate are preferable.

Additional stabilizer can be an amine stabilizer.

Examples of the amine stabilizer include hindered amines, and specifically, compounds, known as HALS, that include bis(2,2,6,6-tetramethyl-4-piperidinyl)sebacate in the basic structure.

These compounds may be used either alone or in a combination of two or more. However, the phenolic stabilizer and the amine stabilizer may react with each other and lose activity when used together. For this reason, when using more than one stabilizer, it is preferable to use the same kind of stabilizer.

While the phenolic stabilizer and the amine stabilizer provide synergy for the withstand voltage characteristics when used with the fullerene, they may react with polyester and inhibit crystallization characteristic when added to polyester resin in particular. It is therefore preferable that the phenolic stabilizer and the amine stabilizer be added in as small an amount as possible. The amount of component (B) added is preferably from 1 to 50,000 ppm, more preferably 1 to 10,000 ppm, further preferably 100 to 5,000 ppm, particularly preferably 500 to 1,000 ppm with respect to the weight of the crystalline thermoplastic resin. When the amount of component (B) added is below the lower limit, sufficient synergy may not be provided for the withstand voltage characteristics. On the other hand, when added in excess of the upper limit, the component (B) may react with the polyester resin and inhibit crystallization characteristic. Because this lowers the break strength, high tension cannot be applied during the process of continuous film take-up, and the film may heat degrade in the metallization step.

<Blend Ratio of Component (A) and Component (B)>

In the present invention, when adding component (B) in the film, it is preferable that the blend ratio of (A) fullerene and (B) at least one component selected from the group consisting of a phenolic stabilizer and an amine stabilizer, as represented by Formula (1) below, be at least 0.001 and at most 1.0.

$$\text{Amount of (A) fullerene added (ppm)/(amount of (A)}$$
$$\text{fullerene added (ppm) + amount of (B) stabilizer added}$$
$$\text{(ppm)) ... (1)}$$

More preferably, the blend ratio of component (A) and component (B) as represented by Formula (1) is at least 0.4 and at most 0.8. When the blend ratio of component (A) and component (B) is below the lower limit, the component (B) may not be able to produce synergy. Further, formability of the film may be impaired by blending component (B). On the other hand, when the blend ratio of component (A) and component (B) is in excess of the upper limit, the component (B) may not be able to produce synergy.

<(C) Sulfur Stabilizer and Phosphorus Stabilizer>

A film of the present invention may further include a small amount of (C) at least one component selected from the group consisting of a sulfur stabilizer and a phosphorus stabilizer, when (A) the fullerene, and at (B) least one component selected from the group consisting of a phenolic stabilizer and an amine stabilizer are contained in the film as the essential components. The withstand voltage characteristics can be further improved by using these stabilizers with (A) the fullerene and (B) the phenolic stabilizer or the amine stabilizer.

Examples of the sulfur stabilizer include thioether compounds, and specifically tetraester-type high molecular thioether compounds.

Examples of the phosphorus stabilizer include phosphonic acid, phosphate compounds, and phosphite compounds. Various kinds of phosphite compounds can be used among these.

The content of component (C) is preferably 1 to 50,000 ppm, more preferably 1 to 10,000 ppm, further preferably 5 to 5,000 ppm with respect to the weight of the crystalline thermoplastic resin. The sulfur stabilizer and the phosphorus stabilizer can further improve the withstand voltage characteristics when used with (A) the fullerene, and (B) the phenolic stabilizer or the amine stabilizer. However, because increasing the amount of these stabilizers does not lead to a corresponding increase in the synergy they provide, it is preferable to add these stabilizers in as small an amount as possible.

When the content of component (C) is below the lower limit, sufficient synergy may not be provided for the withstand voltage characteristics. Adding component (C) beyond the upper limit does not accompany a corresponding increase in synergy. Even worse, the intrinsic heat resistance of the thermoplastic resin may be impaired.

<Inert Particles>

A film of the present invention may include inert particles to make the take-up of the film easier during film formation. The inert particles may be at least one selected from inorganic particles, for example, such as calcium carbonate, silica, talc, and clay; organic particles of thermoplastic resin or heat curable resin such as silicone and acryl; and a pigment such as barium sulfate and titanium oxide. The inert particles can be used as long as it is not detrimental to the effects of the present invention. For example, inert particles having an average particle diameter of 0.001 to 5 $\mu$m can be used. Preferably, the average particle diameter of the inert particles is 0.01 to 3 $\mu$m.

For example, the lower limit of the inert particle content is 0.0001 weight%, preferably 0.01 weight%, more preferably 0.05 weight% with respect to the weight of the crystalline thermoplastic resin film. For example, the upper limit of the inert particle content is 10 weight%, preferably 5 weight%, more preferably 1 weight%, particularly preferably 0.1 weight% with respect to the weight of the crystalline thermoplastic resin film.

The content of the inert particles is defined as the particle ratio (weight%) with respect to the weight of the crystalline thermoplastic resin film, as determined from the centrifuged particles in a selected film-dissolving solvent that dissolves the crystalline thermoplastic resin but does not dissolve the inert particles.

<Withstand Voltage Characteristics>

The withstand voltage characteristics of a biaxially oriented film of the present invention is evaluated based on the breakdown voltage. In a biaxially oriented film of the present invention, the difference of breakdown voltages at 25°C and 150°C (also referred to as "BDV t25-t150) is preferably 130 V/$\mu$m or less, more preferably 100 V/$\mu$m or less, particularly preferably 85 V/$\mu$m or less. When the breakdown voltage difference is in excess of the upper limit, the electrical characteristics of the film will be insufficient when used as, for example, a capacitor, particularly at high temperatures, and the film may not be used desirably in high temperature applications.

The breakdown voltage difference of the foregoing range can be achieved when at least one selected from the group consisting of polyester resin, polypropylene resin, polyphenylene sulfide resin, and syndiotactic polystyrene resin is used as the crystalline thermoplastic resin, and when the biaxially oriented film includes a predetermined amount of fullerene. The breakdown voltage difference can be reduced particularly when polyethylene-2,6-naphthalene dicarboxylate is used as the crystalline thermoplastic resin.

The breakdown voltage of the biaxially oriented film at 25°C is preferably 370 V/$\mu$m or more, more preferably 380 V/$\mu$m or more, further preferably 390 V/$\mu$m or more, particularly preferably 400 V/$\mu$m or more. Further, the breakdown voltage of the biaxially oriented film at 150°C is preferably 210 V/$\mu$m or more, more preferably 250 V/$\mu$m or more, further preferably 270 V/$\mu$m or more, particularly preferably 280 V/$\mu$m or more, most preferably 290 V/$\mu$m or more. These breakdown voltages, as with the breakdown voltage difference, can be achieved when at least one selected from the group consisting of polyester resin, polypropylene resin, polyphenylene sulfide resin, and syndiotactic polystyrene resin is used as the crystalline thermoplastic resin, and when the biaxially oriented film includes a predetermined amount of fullerene.

The breakdown voltages at 25°C and 150°C can be further increased by using a titanium compound as a catalyst.

The breakdown voltages at 25°C and 150°C can also be increased by using the phenolic stabilizer and/or the amine stabilizer with the fullerene.

The breakdown voltage at 25°C is the voltage measured under direct current at the voltage increasing rate of 0.1 kV/s according to the plate electrode method described in JIS C2151, using a device ITS-6003 (Tokyo Seiden Co., Ltd.), as will be described in the measurement method section below. The breakdown voltage at 150°C is the voltage measured under direct current at the voltage increasing rate of 0.1 kV/s in the test atmosphere silicon oil at 150°C according to JIS K6911, using a withstand voltage tester TOS5101 (Kikusui Electronics Corporation), as will be described in the measurement method section below. The breakdown voltage difference (BDV t25-t150) is determined by subtracting the breakdown voltage at 150°C from the breakdown voltage at 25°C.

The present invention evaluates two breakdown voltages at 25°C and 150°C as a measure of withstand voltage characteristics over a temperature range from room temperature to higher temperatures. It should be noted that the breakdown voltage of the resin film continuously decreases as the temperature rises, and drops abruptly at a certain temperature. Thus, the breakdown voltage difference between 25°C and 150°C measured in the present invention is technically significant in the following respects: It shows that a decrease in breakdown voltage with temperature increase is smaller than that in a film solely made of resin; and there is no abrupt decrease in breakdown voltage between 25°C and 150°C.

<Crystallization Characteristic>

A biaxially oriented film of the present invention, by inclusion of fullerene, improves the withstand voltage characteristics of the film, and the crystallization characteristic of the crystalline thermoplastic resin. Specifically, in the crystallization characteristic of a biaxially oriented film of the present invention, the melting point is shifted more toward the high temperature side than the normally observed temperatures. The melting point is determined from the crystallization peak of the film measured using a differential thermal analyzer (DSC). As a reference, the same measurement is made for the crystalline thermoplastic resin forming a reference film. It is preferable that the melting point of the film of the present invention, compared with the reference, be more toward the high temperature side than the melting point of the reference film.

For example, in polyethylene-2,6-naphthalene dicarboxylate, the crystallization peak is generally observed in the vicinity of 265°C (crystal melting point), as measured in a nitrogen atmosphere at a temperature increasing rate of 20°C /min using a differential thermal analyzer (DSC). In a biaxially oriented film of the present invention, by inclusion of fullerene, the melting point is shifted toward the high temperature side, and the crystallization peak is observed in the vicinity of 270°C. Such a crystallization characteristic improves the break strength of the film, and enables component (B) to provide synergy for the withstand voltage characteristics without inhibiting crystallization, when the film additionally contains a predetermined amount of (B) at least one component selected from the group consisting of a phenolic stabilizer and an amine stabilizer.

<Film Break Strength>

A biaxially oriented film of the present invention, by inclusion of fullerene, improves the withstand voltage characteristics of the film, and the break strength of the film. It is believed that the improvement in the break strength of the film is based on the effect of fullerene improving the crystallization characteristic of the crystalline thermoplastic resin.

In the present invention, the film break strength is represented by the break strength of the film along the direction of continuous film formation, and is also referred to as "MD film break strength" or "lengthwise film break strength." The film break strength is preferably at least 290 MPa, more preferably at least 300 MPa, further preferably at least 305 MPa, particularly preferably at least 310 MPa, most preferably at least 315 MPa. With the film break strength confined in these ranges, the film can be taken up under high tension, and the heat degradation due to metallization (wrinkles caused by the heat of metallization) can be prevented.

<Laminate Structure>

A biaxially oriented film of the present invention encompasses both a single layer- and multilayer-laminate structures. When the film is a laminate of two or more layers, the film must include at least one layer containing the crystalline thermoplastic resin and (A) the fullerene. In the case of a laminate of three or more layers, the film preferably includes more than one such layer.

<Film Thickness>

The total thickness of the biaxially oriented film of the present invention is preferably 0.1 to 20 μm, more preferably 0.5 to 15 μm, particularly preferably 1.0 to 10 μm. When the film thickness is below the lower limit, film formation is difficult, and the withstand voltage characteristics may be impaired. On the other hand, a film thickness above the upper limit makes it difficult to reduce the size of products such as film capacitors and motor insulating members.

<Coating Layer>

A biaxially oriented film of the present invention may include a coating layer on at least one of the outer surfaces. The coating layer can be obtained by applying a coating material including a binder resin and a solvent onto the biaxially oriented film. Various kinds of thermoplastic resins and heat curable resins can be used for the binder resin. Examples include polyester, polyimide, polyamide, polyester amide, polyolefin, polyvinyl chloride, poly(meth)acrylic acid ester, polyurethane, polystyrene, a copolymer thereof, and a blend thereof. Among these binder resins, a polyester copolymer is particularly preferable. The solvent may be, for example, an organic solvent such as toluene, ethyl acetate, and methylethyl ketone, a mixture thereof, or water.

A coating layer of the present invention may further include a coating-forming component, specifically, a crosslinker, a surfactant, and inert particles. Examples of the surfactant include polyalkylene oxide.

A coating layer of the present invention may be laminated by a method in which a coating material is applied to at least one surface of a biaxially drawn crystalline thermoplastic resin film, followed by drying, or a method in which a stretchable crystalline thermoplastic resin film is dried, drawn, and, as required, heat treated after applying a coating material to the film. As used herein, the "stretchable film" includes an undrawn film, a uniaxially drawn film, and a biaxially drawn film. A particularly preferable example is a lengthwise drawn film that is uniaxially drawn in the film extrusion direction (lengthwise direction).

When coating the crystalline thermoplastic resin film with a coating material, it is preferable that the coating material be applied in a clean atmosphere, or more specifically, in the film forming step. In this way, the adhesion of the coating can be improved. Dust or dirt is easily trapped when the coating is formed on a biaxially drawn, heat-fixed film in a usual coating step, or more specifically, in a separate step from a film producing step.

The coating material can be applied to the crystalline thermoplastic resin film using any of known coating methods, for example, such as a roll coating method, a gravure coating method, a roll brush method, a spray coating method, an air knife coating method, an impregnation method, and a curtain coating method. These methods may be used either individually or in combination.

<Producing Method of Biaxially Oriented Film>

A biaxially oriented film of the present invention can be obtained by first producing a crystalline thermoplastic resin composition including the crystalline thermoplastic resin and the fullerene as the essential components, and then biaxially drawing the composition. The crystalline thermoplastic resin composition can be produced by any of the following four methods.

(1) The fullerene is dissolved in a solvent, and a resin raw material is added to the fullerene solution to perform polymerization reaction.
(2) The fullerene is added at a later stage of the crystalline thermoplastic resin polymerization.
(3) The fullerene is dissolved in a solvent, and a crystalline thermoplastic resin is added to the fullerene solution.
(4) The crystalline thermoplastic resin and fullerene are melt kneaded using a biaxial kneader.

Each of these crystalline thermoplastic resin producing methods (1) to (4) is described below.

In the resin composition producing method (1), fullerene is dissolved in a solvent to prepare a 0.1 wt% to 15 wt% fullerene solution. Then, a resin raw material or an oligomer thereof is added to the fullerene solution to perform polymerization reaction.

The concentration of the fullerene solution is preferably 0.1 wt% to 15 wt%. A concentration below this lower limit is not efficient because a large quantity of solvent is used in this case. On the other hand, when the concentration is in excess of the upper limit, the fullerene may aggregate. The concentration is more preferably 0.3 wt% to 7 wt%, further preferably 0.5 wt% to 3 wt%.

The solvent is preferably those having a solubility of at least 5.0 mg/ml for the fullerene. For example, the solubility for C60 is presented in Fullerene no Kagaku to Butsuri (The University of Nagoya Press), and examples of the solvents having a solubility of 5.0 mg/ml include decalin, tetrachloroethane, xylenes, trimethylbenzenes, tetramethylbenzenes, tetralin, dibromobenzenes, anisole, chlorobenzene, dichlorobenzenes, trichlorobenzenes, naphthalenes, pyridine, 2-methylthiophene, and carbon disulfide.

When the crystalline thermoplastic resin is polyethylene-2,6-naphthalene dicarboxylate, it is preferable to use, for example, naphthalenes, which have the highest solubility for the fullerene among these examples, and desirable compatibility with the resin. Examples of the naphthalenes include naphthalene; alkylnaphthalenes such as 1-methylnaphthalene, 2-methylnaphthalene, and dimethylnaphthalene; 1-phenylnaphthalene; halogenated naphthalenes such as 1-chloronaphthalene and 1-bromo-2-methylnaphthalene; diaminonaphthalene; and esters such as 2,6-dimethylnaphthalene dicarboxylic acid ester.

In actual practice, the solvent is selected according to such factors as the pyrolysis temperature of the resin. When a solvent having a boiling point in excess of 350°C is used, the solvent may be left in the resin as the pyrolysis proceeds. The solvent left in the resin may cause deterioration of mechanical and thermal properties by the plasticizing effect. Thus, the boiling point of the solvent is preferably less than 320°C, more preferably less than 300°C. The solvent is most preferably naphthalene, 1-methylnaphthalene, 2-methylnaphthalene, or dimethylnaphthalene.

When higher fullerenes other than C60 or C70 are contained, the solubility may decrease, and the fullerene may aggregate in the resin. In this case, it is preferable to dissolve the fullerene in a solvent, and remove those fullerenes having poor solubility, for example, by filtration.

In the resin composition producing method (2), a predetermined amount of fullerene is directly added to a molten resin at a later stage of the polymerization reaction of the crystalline thermoplastic resin polymerized by a known method.

In the resin composition producing method (3), the fullerene is dissolved in a solvent to prepare a 0.1 wt% to 15 wt% fullerene solution. Then, a crystalline thermoplastic resin is added to the fullerene solution to prepare a 1% to 80% polymer-doped solution, and the solvent is removed from the polymer-doped solution.

The concentration of the polymer-doped solution is preferably 1% to 80%. A concentration below this lower limit is not efficient because a large quantity of solvent is required in this case. On the other hand, when the dope concentration is in excess of the upper limit, the fullerene may aggregate. The concentration of the polymer-doped solution is more preferably 20% to 60%, further preferably 30% to 50%.

In the resin composition producing method (4), the crystalline thermoplastic resin and fullerene are melt kneaded using a biaxial kneader. In one exemplary method, a predetermined amount of fullerene is added to a solid resin, mixed, and melt kneaded using a biaxial kneader. In another exemplary method, a resin is melted before adding a predetermined amount of fullerene, and the mixture is melt kneaded using a biaxial kneader.

In methods (2) and (4), the fullerene may be added either directly or after preparing the master polymer. The concentration of the fullerene in the master polymer is preferably 0.1 to 10 weight%. A concentration below this lower limit may be inefficient because the amount of master polymer will be increased in this case. On the other hand, a concentration in excess of the upper limit may pose difficulties in the production of the master polymer.

The amount of fullerene added may be adjusted by a method in which the fullerene-containing polymer obtained in the methods (1) to (4) is used as the master polymer, and a fullerene-free polymer is melt kneaded with the master polymer using a biaxial kneader.

Further, when the crystalline thermoplastic resin composition further includes (B) at least one component selected from the group consisting of a phenolic stabilizer and an amine stabilizer, and at least (C) one component selected from the group consisting of a sulfur stabilizer and a phosphorus stabilizer, the component (B) and the component (C) may be added according to the method of adding (A) fullerene described in (2) and (4) above.

<Film Forming Method>

A method for obtaining a biaxially oriented film of the present invention is described below in detail. Note, however, that the method is not limited to the examples below.

The resin composition obtained in any of the methods (1) to (4) is dried as required, and fed to an extruder to be formed into a sheet through a T die.

The formed sheet extruded through the T die is cooled and solidified to form an undrawn film using a cooling drum having a surface temperature of 10 to 60°C. The undrawn film is heated by, for example, roll heating or infrared ray heating, and drawn in the lengthwise direction to obtain a lengthwise drawn film. Preferably, the lengthwise drawing is performed by taking advantage of the difference in the circumferential speed of two or more rollers. It is preferable that the lengthwise drawing temperature be higher than the glass transition point (Tg) of the resin, preferably higher than the glass transition point (Tg) by 20 to 40°C. The lengthwise draw rate may be appropriately adjusted as required in the intended application, and is preferably at least 2.5 and at most 5.0, more preferably at least 3.0 and at most 4.5. When the lengthwise draw rate is below the lower limit, the thickness of the film may become uneven, and a desirable film may not be obtained. When the lengthwise draw rate is in excess of the upper limit, the incidence of film breakage is increased during film formation.

The lengthwise drawn film obtained as above is drawn transversely, followed by a subsequent heat fix and a heat relax treatment as required to obtain a biaxially oriented film. Here, the film is processed as it travels.

The transverse drawing is performed by increasing temperature from the temperature 20°C above the glass transition point (Tg) of the resin, to the temperature 120 to 30°C below the melting point (Tm) of the resin. The initial temperature of the transverse drawing is preferably (Tg + 40)°C or less. The maximum temperature of the transverse drawing is preferably 100 to 40°C below the melting point (Tm). When the initial temperature of transverse drawing is too low, the film easily breaks. When the maximum temperature of transverse drawing is below (Tm - 120)°C, the thermal shrinkage rate of the resulting film increases, and the film properties are likely to be nonuniform along the width direction. On the other hand, when the maximum temperature of transverse drawing is above (Tm - 30)°C, the film becomes too soft, and easily breaks during formation.

The temperature increase during the process of transverse drawing may be continuous or stepwise (sequential). However, the temperature is usually increased stepwise. For example, the transverse drawing zone of a stenter is divided into plural zones along the film travel direction, and the temperature is increased by flowing a heating medium of a predetermined temperature in each zone.

The transverse draw rate may be appropriately adjusted as required in the intended application, and is preferably at least 2.5 and at most 5.0, more preferably at least 3.0 and at most 4.5. When the transverse draw rate is below the lower limit, the thickness of the film may become uneven, and a desirably film may not be obtained. When the transverse draw rate is in excess of the upper limit, the incidence of film breakage is increased during film formation.

The biaxially drawn film is then heat fixed as required. By the heat fix, the dimensional stability of the film under high temperature conditions can be improved. When using polyethylene-2,6-naphthalene dicarboxylate, a biaxially oriented film of the present invention has a thermal shrinkage rate of preferably -3% to 3%, more preferably -2% to 2%, and particularly preferably -1% to 1% at 200°C. When the thermal shrinkage rate at 200°C does not satisfy the foregoing ranges, wrinkles may occur in the base film or metallized film in the film capacitor made from a laminate film produced by the vapor deposition of the metallized film on the biaxially oriented film. The thermal shrinkage rate at 200°C can be confined in the foregoing ranges by performing the heat fix preferably at the temperature of (Tm - 100°C) and higher, more preferably from (Tm - 70) °C to (Tm - 40)°C.

In order to suppress thermal shrinkage, a biaxially oriented film of the present invention may be subjected to annealing, in which the film is first heat treated in the offline step at 150 to 220°C for 1 to 60 seconds, and then gradually cooled in an atmosphere of 50 to 80°C.

A biaxially oriented film of the present invention may be produced by performing melt kneading after producing a resin composition according to any of the foregoing methods (1) to (4), in order to improve dispersibility of the fullerene, and confine the dispersion particle diameter within a range of 100 nm or less. The kneading method is not particularly limited, and can be performed using a uniaxial or a biaxial extruder and a kneader. The melt knead temperature is preferably a temperature 5 to 100°C above the melting temperature of the resin component, particularly preferably a temperature 10 to 60°C above the melting point of the resin. When the melt knead temperature is too high, the resin may undergo decomposition or abnormal reaction. The kneading time is at least 30 seconds and at most 15 minutes, preferably 1 to 10 minutes.

<Functional Layer>

A biaxially oriented film of the present invention may be a biaxially oriented laminate film additionally including a functional layer laminated on at least one of the surfaces to impart other functions.

For example, for the purpose of improving the self healing property, a layer including an oxygen atom-containing compound may be provided on at least one surface of the biaxially oriented film. On the surface of the layer containing an oxygen atom-containing compound, the percentage of the oxygen atom with respect to the carbon atom is preferably 10% or more, more preferably 15% or more, as measured using an X-ray photoelectron spectroscopy. Examples of the oxygen atom-containing compound include cellulose and $SiO_2$. In the case of $SiO_2$, the layer may be laminated by any of a vacuum vapor deposition method, ion plating, and sputtering.

The functional layer may be a metal layer. The material of the metal layer is not particularly limited, and aluminum, zinc, nickel, chromium, tin, copper, and an alloy thereof can be used, for example. The metal layer can be laminated by any of a vacuum vapor deposition method, sputtering, and coating via an adhesive.

Conventionally, when the method of forming the functional layer employs a continuous process in which the functional layer is formed on the film while the film is being continuously taken up, the film is exposed to high temperature and heat degrades. Such heat degradation due to metallization does not occur in a biaxially oriented film of the present invention, because the film has a high break strength, and can be taken up under high tension.

For example, in a metallization process employing the continuous film take-up, the metal is continuously vapor deposited on the film adhering to a cooled roller so that the film will not be heat degraded by the heat of the metal vapor, or the radiated heat from the molten metal surface or the surroundings. However, depending on the deposition rate, sufficient adhesion may not be obtained between the cooling roller and the film, and the heat degradation becomes likely in this case. The heat degradation due to metallization can be prevented regardless of the deposition rate when a biaxially oriented film of the present invention is used and taken up under high tension.

<Use>

A biaxially oriented film of the present invention has excellent withstand voltage characteristics over a temperature range from room temperature to higher temperatures, and therefore can be suitably used as an electrical insulating film, particularly as an electrical insulating film intended for electrical insulation in high temperature applications. Specifically, the film can be used in applications where the film is processed or used at high temperatures and requires electrical insulation, such as in film capacitors; motor insulating members such as wedge material and slot material; and electrically insulating base films for devices such as a flexible electronics device. More specifically, the film can be used as the base film of flexible electronics devices, for example, such as in a flexible printed circuit board, a flat cable, and a solar cell. Other applications include electrical insulating members of fuel cells.

For example, the film capacitor, one example of the electrical insulation applications, includes a constituting member obtained by winding or laminating a plurality of composite films each including a metal layer laminated on one surface of a biaxially oriented film of the present invention.

Further, in the present invention, a film capacitor constituting member refers to film capacitor constituting members including a composite film that includes: a biaxially oriented film of the present invention; and a metal layer laminated on at least one surface of the biaxially oriented film.

The flexible printed circuit board can be obtained by laminating a metal layer of a copper foil or a conductive paste on at least one surface of a biaxially oriented film of the present invention, and forming fine circuit patterns on the metal layer.

The motor insulating members such as wedge material or slot material can be obtained by using a biaxially oriented film of the present invention as a motor insulating film, and deforming it with a rounded punch.

Among these electrical insulation applications, the film is particularly suitable in applications involving a continuous process in which a functional layer is formed on the film while the film is continuously being taken up, such as in film capacitors and flexible printed circuit boards.

Examples

The following describes the present invention in detail based on examples. It should be noted that the scope of the present invention is not limited in any ways by the following descriptions. In the examples, each item was measured and evaluated according to the methods described below. Further, "parts" and "%" in the examples mean "parts by weight" and "weight%", respectively, unless otherwise specified.

(1) Breakdown Voltage at Room Temperature

The breakdown voltage of a biaxially oriented film obtained was measured at a voltage increasing rate of 0.1 kV/sec according to the plate electrode method of the DC test described in JIS C2151, using ITS-6003 (Tokyo Seiden Co., Ltd.). The voltage at break was measured as the breakdown voltage. In the measurement, n = 50, and the mean value was used as the breakdown voltage. Measurement was made at room temperature (25°C).

(2) Breakdown Voltage at High Temperature

The breakdown voltage of a biaxially oriented film obtained was measured at 150°C (n = 3) according to JIS K6911 under the following conditions: Test piece dimension, 10 cm $\times$ 10 cm; electrodes, the upper electrode (spherical, ø = 20 mm), the lower electrode (100 mm $\times$ 100 mm $\times$ 100 $\mu$m thickness), made of stainless steel; voltage increasing rate, 0.1 kV/sec (DC); test atmosphere, silicon oil (JIS c2320 compatible insulating oil); test device, withstand voltage tester TOS5101 (Kikusui Electronics Corporation). The mean value was determined to obtain the breakdown voltage.

(3) Breakdown Voltage Difference (BDV t25-t150)

The breakdown voltage difference was determined by subtracting the breakdown voltage at 150°C from the breakdown voltage at 25°C, using the breakdown voltage values of the respective temperatures determined in the methods (1) and (2).

(4) Melting Point

10 mg of a biaxially oriented film obtained was sealed in an aluminum measurement pan, and the melting peak temperature was determined by measuring the melting point at a temperature increasing rate of 20°C/min, using a differential calorimeter DSC 2920 (TA Instruments).

(5) Film Thickness

Film thickness was measured using an electronic micrometer (K-312A, Anritsu) under a stylus pressure of 30 g.

(6) Measurement of Metal Element in the Film

A flat disc was prepared by fusing 5 g of the film under the heat of 310°C on a hot plate. The disc was measured with an X-ray fluorescence spectrometer 3270E (Rigaku) to find the quantity of each element contained in the disc.

(7) Dispersion Particle Diameter of Fullerene

The dispersion particle diameter was determined from the number average length of the disperse phase of 100 fullerenes along the MD direction, by observing the cross section through the thickness taken along the MD direction of the film, using a light microscope (OPTPHOT-2, 200 x; Nikon).

(8) Film Break Strength

Film break strength was measured using a tensile tester (Tensilon, Toyo Baldwin). A sample (100 mm in length and 10 mm in width) was obtained from a biaxially oriented film obtained. The sample was anchored with a chuck set to 50 mm of interval, and pulled in the lengthwise direction (MD) at a rate of 100 mm/min. The load was measured with a load cell attached to the tester. The load at break was read out from a load-elongation curve, and the reading was divided by the cross sectional area of the sample before pulling to calculate the break strength (MPa).

(9) Film Processability

The film was evaluated under a take-up tension condition in which no heat degradation (wrinkles) occurs when a polyester film containing no additives (Comparative Examples 1 and 2) is subjected to a vapor deposition process at a deposition rate of 300 m/min for 10 minutes using a take-up vacuum vapor deposition device for capacitors, designed to continuously vapor deposit metal onto a plastic film, and the result was rated "A" when no heat degradation (wrinkles) occurred in the film.

The deposition rate and the take-up tension used in the evaluation that had the rating "A" were used as a reference, and a vapor deposition process was performed at a deposition rate of 350 m/min or higher under an increased take-up tension for 10 minutes. The result was rated "AA" when no heat degradation (wrinkles) occurred in the film.

In a vapor deposition process performed for 10 minutes under the same deposition rate and take-up tension conditions as in the evaluation that had the rating "A", the result was rated "B" when there was occasional heat degradation (wrinkles) in the film.

In a vapor deposition process performed for 10 minutes under the same deposition rate and take-up tension conditions as in the evaluation that had the rating "A", the result was rated "C" when heat degradation (wrinkles) occurred frequently and caused a problem in the vapor deposition.

<Preparation Method of Titanium Catalyzed PEN Polymer>

P1:

100 parts of 2,6-naphthalene dicarboxylic acid dimethyl ester (hereinafter, also referred to as "NDC"), 60 parts of ethylene glycol (hereinafter, also referred to as "EG"), and a titanium compound (titanium trimellitate added in 15 mmol% in terms of a titanium element) were charged in an SUS vessel. Then, an ester exchange reaction was performed by increasing the temperature over the range of from 140°C to 240°C. The reaction mixture was transferred to a polymerization reaction vessel, and the temperature was increased to 295°C to allow a polycondensation reaction in a high vacuum of 30 Pa or less. As a result, a polyethylene-2,6-naphthalene dicarboxylate having an inherent viscosity of 0.6 dl/g was obtained.

<Preparation Method of Fullerene-Containing PEN Polymer>

P2:

100 parts by weight of 2-methylnaphthalene, and 0.31 parts by weight of fullerene were charged in a flask, and thoroughly agitated. The temperature was set to about 200°C. Then, polymer P1, dried at 70°C for 6 hours, was added in small portions in a total amount of 63 parts by weight. After agitating the mixture for about 1 to 2 hours, the temperature was gradually increased to a final temperature of 290°C, at which the pressure was reduced to remove 2-methylnaphthalene and obtain a resin composition. The amount of fullerene added was 5,000 ppm with respect to the polymer weight.

C60 (Aldrich) was used as the fullerene.

<Preparation Method of Phenolic Stabilizer-Containing PEN Polymer>

P3:

100 parts of 2,6-naphthalene dicarboxylic acid dimethyl ester, 60 parts of ethylene glycol, a titanium compound (titanium trimellitate added in 15 mmol% in terms of a titanium element), and a phenolic stabilizer (Irganox® 1010; 5,000 ppm with respect to the polymer weight) were charged in an SUS vessel. Ester exchange reaction was performed by increasing the temperature over the range of from 140°C to 240°C. The reaction mixture was transferred to a polymerization reaction vessel, and the temperature was increased to 295°C to allow a polycondensation reaction in a high vacuum of 30 Pa or less. As a result, a polyethylene-2,6-naphthalene dicarboxylate having an inherent viscosity of 0.6 dl/g was obtained.

<Preparation Method of Antimony Catalyzed PEN Polymer>

P4:

Ester exchange reaction was performed using 100 parts by weight of naphthalene-2,6-dicarboxylic acid dimethyl, and 60 parts by weight of ethylene glycol in the presence of manganese acetate, using an ordinary method. Then, antimony trioxide was added (300 ppm in terms of an antimony element), and a polycondensation reaction was performed using an ordinary method to obtain a polyethylene-2,6-naphthalene dicarboxylate. The content of each element in the resin was measured using an atomic absorbance method. The result was Mn = 50 ppm, and Sb = 300 ppm.

<Preparation Method of Fullerene-Containing PEN Polymer>

P5:

A fullerene-containing PEN polymer was prepared as in the method for P2, except that the amount of fullerene with respect to the polymer weight was changed from 5,000 ppm to 10,000 ppm.

P6:

A fullerene-containing PEN polymer was prepared as in the method for P2, except that the amount of fullerene with respect to the polymer weight was changed from 5,000 ppm to 30,000 ppm.

<Preparation Method of Phenolic Stabilizer-Containing PEN Polymer>

P7:

A phenolic stabilizer-containing PEN polymer was prepared as in the method for P3, except that the amount of phenolic stabilizer with respect to the polymer weight was changed from 5,000 ppm to 10,000 ppm.

<Reference Example 1>

Polymer P2 was dried at 180°C for 6 hours, fed to an extruder heated to 300°C, and formed into a sheet through a 290°C dice. The sheet was cooled and solidified on a cooling drum having a surface temperature of 60°C to prepare an undrawn film. The undrawn film was guided to a group of rollers heated to 140°C, and drawn in the longitudinal direction (lengthwise direction) at a rate of 3.6, before it was cooled with 60°C rollers.
Held with clips at the both ends, the lengthwise drawn film was guided to a tenter, where the film was drawn 4.0 times in a direction (transverse direction) perpendicular to the longitudinal direction in an atmosphere heated to create a transverse drawing maximum temperature of 150°C. In the tenter, the film was heat fixed at 210°C for 5 seconds, followed by 1% heat relaxation at 200°C. Then, the film was gradually and evenly cooled to room temperature to obtain a biaxially oriented polyester film having a thickness of 3 μm.

<Reference Examples 2 to 5, Examples 1 to 3, and Comparative Examples 1 to 4>

A biaxially oriented polyester film having a thickness of 3 μm was obtained by the same procedure as in Reference Example 1, except that the polymers shown in Table 1 were used.
As is clear from Table 1, the breakdown voltages at 25°C and 150°C increased as the fullerene content was increased. The breakdown voltage difference between 25°C and 150°C was smaller in the fullerene-containing films than in the fullerene-free films. Further, these withstand voltage characteristics improved when the titanium compound was used as the catalyst, and when the fullerene was used with the phenolic stabilizer. Further, in the fullerene-containing films, the melting point shifted toward the high temperature side, and the film break strength improved. The film processability in the vacuum vapor deposition process also improved. With the phenolic stabilizer, the withstand voltage characteristics improved without inhibiting film processability.

Table 1

| | P1 | P2 | P3 | P4 | P5 | P6 | P7 | (A) Fullerene (ppm) | (B) Phenol (ppm) | (A)/(A)+(B) | Breakdown voltage 25°C (V/μm) | Breakdown voltage 150°C (V/μm) | Breakdown voltage difference (BDV$_{t25-t120}$) (V/μm) | Melting point °C | MD break strength MPa | Film processability |
|---|---|---|---|---|---|---|---|---|---|---|---|---|---|---|---|---|
| Polymer | PEN | PEN | PEN | PEN | PEN | PEN | PEN | | | | | | | | | |
| Catalyst | Ti | Ti | Ti | Sb | Ti | Ti | Ti | | | | | | | | | |
| Additive | - | Fullerenes | Phenols | - | Fullerenes | Fullerenes | Phenols | | | | | | | | | |
| Reference Ex.1 | | 100 | | | | | | 5,000 | 0 | 1.0 | 400 | 300 | 100 | 270 | 315 | AA |
| Reference Ex.2 | 80 | 20 | 20 | | | | | 1,000 | 0 | 1.0 | 395 | 295 | 100 | 270 | 310 | AA |
| Reference Ex.3 | | | | | 100 | | | 10,000 | 0 | 1.0 | 405 | 320 | 85 | 270 | 350 | AA |
| Reference Ex.4 | 98 | 2 | | | | | | 100 | 0 | 1.0 | 380 | 280 | 100 | 270 | 300 | AA |
| Reference Ex.5 | | 20 | | 80 | | | | 1,000 | 0 | 1.0 | 375 | 275 | 100 | 273 | 315 | AA |
| Ex.1 | 60 | 20 | 20 | | | | | 1,000 | 1,000 | 0.5 | 415 | 330 | 85 | 270 | 305 | AA |
| Ex.2 | 70 | 20 | 10 | | | | | 1,000 | 500 | 0.67 | 410 | 325 | 85 | 270 | 305 | AA |
| Ex.3 | | | | | 50 | | 50 | 5,000 | 5,000 | 0.5 | 420 | 335 | 85 | 270 | 310 | AA |
| Com.Ex.1 | 100 | | | | | | | 0 | 0 | - | 350 | 200 | 150 | 265 | 280 | A |
| Com.Ex.2 | | | | 100 | | | | 0 | 0 | - | 330 | 190 | 140 | 266 | 285 | A |
| Com.Ex.3 | | 100 | 100 | | | | | 0 | 5,000 | - | 380 | 260 | 120 | 263 | 270 | B |
| Com.Ex.4 | | | | | | 100 | | 30,000 | 0 | 1.0 | No film formation | | | - | - | - |

EP 2 128 189 B1

Industrial Applicability

A film of the present invention includes fullerene in a crystalline thermoplastic resin film, wherein the crystalline thermoplastic resin is a polyester resin and therefore has excellent withstand voltage characteristics over a temperature range from room temperature to higher temperatures. By the inclusion of fullerene, the film also has excellent processability, causing no heat degradation in the film being continuously processed to form a functional layer thereon while the film is continuously being taken up. The film is therefore suitable as a film for electrical insulation.

**Claims**

1. A biaxially oriented film for electrical insulation of at least a single layer comprising a crystalline thermoplastic resin, wherein the crystalline thermoplastic resin is polyester resin, **characterized in that** the film contains (A) a fullerene added in an amount of 10 to 20,000 ppm with respect to a weight of the crystalline thermoplastic resin, wherein the film further comprises (B) at least one phenolic stabilizer added in an amount of 1 to 50,000 ppm with respect to the weight of the crystalline thermoplastic resin.

2. The biaxially oriented film for electrical insulation according to claim 1, wherein the fullerene is at least one selected from the group consisting of C60, C70, a dimer thereof, and a trimer thereof.

3. The biaxially oriented film for electrical insulation according to claim 1, wherein the fullerene in the film has a dispersion particle diameter of 100 nm or less.

4. The biaxially oriented film for electrical insulation according to claim 1, wherein the fraction of (A) the fullerene with respect to a total amount of (A) the fullerene and (B) the at least one phenolic stabilizer is at least 0.001 and at most 1.0 in the formula (1) below:

$$\text{Amount of (A) fullerene added (ppm)/(amount of (A) fullerene added (ppm) + amount of (B) stabilizer added (ppm)) } \ldots \text{ (1).}$$

5. The biaxially oriented film for electrical insulation according to claim 1, further comprising at least one component (C) selected from the group consisting of a sulphur stabilizer and a phosphorus stabilizeradded in an amount of 1 to 50,000 ppm with respect to the weight of the crystalline thermoplastic resin.

6. The biaxially oriented film for electrical insulation according to claim 1, further comprising 0.0001 to 0.1 weight% of inert particles.

7. The biaxially oriented film for electrical insulation according to claim 1, wherein the polyester resin is polyethylene-2,6-naphthalene dicarboxylate.

8. The biaxially oriented film for electrical insulation according to claim 1, wherein a catalyst of the polyester resin is a titanium compound.

9. The biaxially oriented film for electrical insulation according to claim 1, wherein the film is used for film capacitors or motor insulation.

10. The biaxially oriented film for electrical insulation according to clam 1, wherein the film has a difference of breakdown voltages at 25°C and 150°C of 85 V/$\mu$m or less.

11. A biaxially oriented laminate film, which comprises a metal layer laminated on at least one surface of a biaxially oriented film for electrical insulation of claim 1.

12. A film capacitor base film, which comprises a biaxially oriented film for electrical insulation of claim 1.

13. A film capacitor constituting member, which comprises a composite film including: a biaxially oriented film for electrical insulation of claim 1; and a metal layer laminated on at least one surface of the biaxially oriented film.

**14.** A film capacitor, which comprises a constituting member formed by lamination of a plurality of composite films each including: a biaxially oriented film for electrical insulation of claim 1; and a metal layer laminated on at least one surface of the biaxially oriented film.

**15.** A motor insulating film, which comprises a biaxially oriented film for electrical insulation of claim 1.

**16.** A motor insulating member, which comprises a biaxially oriented film for electrical insulation of claim 1.

**Patentansprüche**

**1.** Biaxial orientierte Folie zur elektrischen Isolierung aus mindestens einer Schicht, die ein kristallines thermoplastisches Harz umfasst, wobei es sich bei dem kristallinen thermoplastischen Harz Polyesterharz handelt, **dadurch gekennzeichnet, dass** die Folie (A) ein Fulleren in einer Zusatzmenge von 10 bis 20.000 ppm, bezogen auf das Gewicht des kristallinen thermoplastischen Harzes, enthält, wobei die Folie ferner (B) mindestens einen phenolischen Stabilisator in einer Zusatzmenge von 1 bis 50.000 ppm, bezogen auf das Gewicht des kristallinen thermoplastischen Harzes, umfasst.

**2.** Biaxial orientierte Folie zur elektrischen Isolierung nach Anspruch 1, wobei es sich bei dem Fulleren um mindestens ein Mitglied der Gruppe bestehend aus C60, C70, einem Dimer davon und einem Trimer davon handelt.

**3.** Biaxial orientierte Folie zur elektrischen Isolierung nach Anspruch 1, wobei das Fulleren in der Folie einen Dispersionsteilchendurchmesser von 100 nm oder weniger aufweist.

**4.** Biaxial orientierte Folie zur elektrischen Isolierung nach Anspruch 1, wobei der Anteil (A) des Fullerens, bezogen auf eine Gesamtmenge von (A) dem Fulleren und (B) dem mindestens einen phenolischen Stabilisator, mindestens 0,001 und höchstens 1,0 in der nachstehenden Formel (1) beträgt:

```
Zusatzmenge von (A) Fulleren (ppm)/( Zusatzmenge
von (A) Fulleren (ppm) + Zusatzmenge von (B)
Stabilisator (ppm))... (1).
```

**5.** Biaxial orientierte Folie zur elektrischen Isolierung nach Anspruch 1, ferner umfassend mindestens eine Komponente (C) aus der Gruppe bestehend aus einem Schwefel-Stabilisator und einem Phosphor-Stabilisator in einer Zusatzmenge von 1 bis 50.000 ppm, bezogen auf das Gewicht des kristallinen thermoplastischen Harzes.

**6.** Biaxial orientierte Folie zur elektrischen Isolierung nach Anspruch 1, ferner umfassend 0,0001 bis 0,1 Gew.-% inerte Teilchen.

**7.** Biaxial orientierte Folie zur elektrischen Isolierung nach Anspruch 1, wobei es sich bei dem Polyesterharz um Polyethylen-2,6-naphthalindicarboxylat handelt.

**8.** Biaxial orientierte Folie zur elektrischen Isolierung nach Anspruch 1, wobei es sich bei einem Katalysator des Polyesterharzes um eine Titanverbindung handelt.

**9.** Biaxial orientierte Folie zur elektrischen Isolierung nach Anspruch 1, wobei die Folie für Folienkondensatoren oder für die Motorisolierung verwendet wird.

**10.** Biaxial orientierte Folie zur elektrischen Isolierung nach Anspruch 1, wobei die Folie eine Differenz von Durchschlagspannungen bei 25°C und 150°C von 85 V/$\mu$m oder weniger aufweist.

**11.** Biaxial orientierte Laminatfolie, die eine auf mindestens eine Oberfläche einer biaxial orientierten Folie zur elektrischen Isolierung gemäß Anspruch 1 auflaminierte Metallschicht umfasst.

**12.** Folienkondensator-Grundfolie, die eine biaxial orientierte Folie zur elektrischen Isolierung gemäß Anspruch 1 umfasst.

**13.** Folienkondensator-Aufbauglied, dass eine Verbundfolie, die eine biaxial orientierte Folie zur elektrischen Isolierung gemäß Anspruch 1 und eine auf mindestens eine Oberfläche der biaxial orientierten Folie auflaminierte Metallschicht enthält, umfasst.

**14.** Folienkondensator, der ein durch Laminieren mehrerer Verbundfolien, die jeweils eine biaxial orientierte Folie zur elektrischen Isolierung gemäß Anspruch 1 und eine auf mindestens eine Oberfläche der biaxial orientierten Folie auflaminierte Metallschicht enthalten, gebildetes Aufbauglied umfasst.

**15.** Motorisolierfolie, die eine biaxial orientierte Folie zur elektrischen Isolierung gemäß Anspruch 1 umfasst.

**16.** Motorisolierglied, das eine biaxial orientierte Folie zur elektrischen Isolierung gemäß Anspruch 1 umfasst.


**Revendications**

**1.** Film à orientation biaxiale pour une isolation électrique, constitué d'au moins une monocouche comprenant une résine thermoplastique cristalline, la résine thermoplastique cristalline étant une résine de polyester, **caractérisé en ce que** le film contient (A) un fullerène ajouté dans une quantité de 10 à 20 000 ppm relativement à un poids de la résine thermoplastique cristalline, le film comprenant en outre (B) au moins un stabilisant phénolique ajouté dans une quantité de 1 à 50 000 ppm relativement au poids de la résine thermoplastique cristalline.

**2.** Film à orientation biaxiale pour une isolation électrique selon la revendication 1, dans lequel le fullerène est un élément au moins du groupe constitué de fullerène C60, de fullerène C70, d'un dimère de ceux-ci, et d'un trimère de ceux-ci.

**3.** Film à orientation biaxiale pour une isolation électrique selon la revendication 1, dans lequel le fullerène présent dans le film a un diamètre de particule en dispersion de 100 nm ou moins.

**4.** Film à orientation biaxiale pour une isolation électrique selon la revendication 1, dans lequel la fraction de (A) le fullerène relativement à une quantité totale de (A) le fullerène et (B) ledit au moins un stabilisant phénolique est d'au moins 0,001 et d'au maximum 1,0 dans la formule (1) ci-dessous :

```
        quantité de (A) fullerène ajouté (ppm)/(quantité
    de (A) fullerène ajouté (ppm) + quantité de (B)
    stabilisant ajouté (ppm))                    (1).
```

**5.** Film à orientation biaxiale pour une isolation électrique selon la revendication 1, comprenant en outre au moins un constituant (C) sélectionné dans le groupe constitué d'un stabilisant à base de soufre et d'un stabilisant à base de phosphore ajouté dans une quantité de 1 à 50 000 ppm relativement au poids de la résine thermoplastique cristalline.

**6.** Film à orientation biaxiale pour une isolation électrique selon la revendication 1, comprenant en outre 0,0001 % à 0,1 % en poids de particules inertes.

**7.** Film à orientation biaxiale pour une isolation électrique selon la revendication 1, dans lequel la résine de polyester est un dicarboxylate de polyéthylène-2,6-naphtalène.

**8.** Film à orientation biaxiale pour une isolation électrique selon la revendication 1, dans lequel un catalyseur de la résine de polyester est un composé de titane.

**9.** Film à orientation biaxiale pour une isolation électrique selon la revendication 1, le film étant utilisé pour l'isolation de condensateurs à film ou de moteurs.

**10.** Film à orientation biaxiale pour une isolation électrique selon la revendication 1, une différence entre les tensions de claquage du film à 25 °C et à 150 °C étant de 85 V/$\mu$m ou moins.

**11.** Film stratifié à orientation biaxiale, lequel comprend une couche métallique appliquée par stratification sur au moins une surface d'un film à orientation biaxiale pour une isolation électrique selon la revendication 1.

12. Film de base pour condensateur à film, lequel comprend un film à orientation biaxiale pour une isolation électrique selon la revendication 1.

13. Élément constitutif d'un condensateur à film, lequel comprend un film composite comportant : un film à orientation biaxiale pour une isolation électrique selon la revendication 1 ; et une couche métallique appliquée par stratification sur au moins une surface du film à orientation biaxiale.

14. Condensateur à film, lequel comprend un élément constitutif formé par stratification d'une pluralité de films composites comportant chacun : un film à orientation biaxiale pour une isolation électrique selon la revendication 1 ; et une couche métallique appliquée par stratification sur au moins une surface du film à orientation biaxiale.

15. Film pour l'isolation d'un moteur, lequel comprend un film à orientation biaxiale pour une isolation électrique selon la revendication 1.

16. Élément pour l'isolation d'un moteur, lequel comprend un film à orientation biaxiale pour une isolation électrique selon la revendication 1.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000173855 A
- JP 2005289065 A

- JP 2006282971 A

**Non-patent literature cited in the description**

- Fullerene no Kagaku to Butsuri. The University of Nagoya Press